# Europäisches Patentamt

## European Patent Office

## Office européen des brevets

(11) Publication number: **0 092 731**
**B1**

(12) **EUROPEAN PATENT SPECIFICATION**

(45) Date of publication of patent specification: **19.07.89**

(51) Int. Cl.⁴: **G 06 F 15/02**

(21) Application number: **83103500.1**

(22) Date of filing: **11.04.83**

(54) A pocket electronic calculator.

(30) Priority: **15.04.82 JP 55165/82 u
27.09.82 JP 168770/82**

(43) Date of publication of application:
**02.11.83 Bulletin 83/44**

(45) Publication of the grant of the patent:
**19.07.89 Bulletin 89/29**

(84) Designated Contracting States:
**DE FR GB**

(56) References cited:
**EP-A-0 005 661
US-A-4 115 705
US-A-4 202 607
US-A-4 261 042
US-A-4 264 962**

**Nikkei Electronics, 1981, 6-8, pp. 84-87, "NE
Report"**

**National Technical Report, 1981, 12, pp. 75-81,
"Paper Battery"**

(73) Proprietor: **Matsushita Electric Industrial Co.,
Ltd.
1006, Oaza Kadoma
Kadoma-shi Osaka-fu, 571 (JP)**

(72) Inventor: **Nitta, Jin-e
767-25, Nase-cho
Totsuka-ku Yokohama City, 245 (JP)**
Inventor: **Horie, Kenzo
749-1, Saedo-cho
Midori-ku Yokohama City, 226 (JP)**

(74) Representative: **Dr. Elisabeth Jung Dr. Jürgen
Schirdewahn Dipl.-Ing. Claus Gernhardt
P.O. Box 40 14 68 Clemensstrasse 30
D-8000 München 40 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Description

## Background of the Invention

### 1. Field of the Invention

The present invention relates to a small type pocket electronic calculator.

### 2. Description of the Prior Art

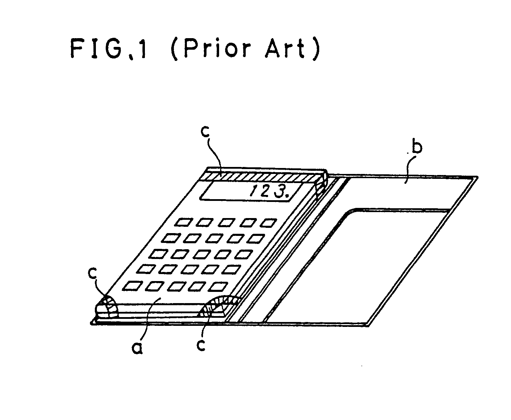

FIG. 1 shows an embodiment of a conventional small pocket electronic calculator. In FIG. 1, a body(a) of the calculator is set in a pocket notebook-shaped case(b) and a plastic belt(c) is provided to fix the body(a) of the calculator to the case(b). Usually the body(a) is used together with the case(b) for protecting the body(a) and for a convenience to carry the body(a). However, concerning such calculator, the body(a) and the case(b) are fundamentally different things, therefore the calculator has such defects that, firstly, when the body(a) is set in the case(b) the thickness of the calculator necessarily increases, secondly, said setting of the body(a) takes much time, and thirdly, after setting, when a considerable vibration or a shock is given to said calculator, the body(a) will be liable to slip out from the case(b). Furthermore, since the body(a) is made of rigid material, namely plastics or metal, etc., it is necessary to take care that an excessive force is not given to the body(a) when the body(a) is carried. And since the body(a) is made of said rigid material, general impression upon user about the body(a) is that it tends to be cool and hard. Therefore, the material of the body(a) restrains free use. A pocket electronic calculator of the type specified in the preamble of Claim 1 is known from US—A—4261042.

## Summary of the Invention

This invention as claimed in Claim 1 offers a pocket electronic calculator which is small in size and resistant to fracture.

Further object of this invention is to offer a pocket electronic calculator which can be bent and is waterproof, or further has a card pocket or further has a display part that can be used also as a mirror.

## Brief Explanation of the Drawings

FIG. 1 is a perspective view showing an external appearance of a conventional small pocket electronic calculator.

FIG. 2 is a cross-sectional view showing an embodiment of a pocket electronic calculator of the present invention. The thicknesses of the members of this embodiment are illustrated exaggeratedly.

FIG. 3 is a plan view showing an external appearance of the embodiment of the present invention when it is used for calculation.

FIG. 4 is a perspective view showing an external appearance of the embodiment of the present invention when it is carried.

FIG. 5 is an exploded perspective view of said embodiment of the present invention.

FIG. 6 is a plan view of another embodiment of the present invention.

FIG. 7 is a plan view of still another embodiment of the present invention.

## Description of the Preferred Embodiment

A pocket electronic calculator in accordance with the present invention comprises

an external member made of a rectangular sheet material having flexibility,

an internal member made of a rectangular sheet material having flexibility, said external member and said internal member being connected at their peripheral parts,

a first film-type printed circuit substrate which is held on the inner surface of said external member and on which substrate a calculation circuit is formed,

a push-key cover sheet which is fixed on a part of said internal member,

a second printed circuit substrate which forms a key switch coupled with said push-key cover sheet,

display means and battery holding means which are connected to corresponding parts of said internal member,

a third flexible printed circuit substrate whose one terminal is electrically connected to said first film-type printed circuit substrate and whose other terminal is connected to said display means and said battery holding means.

An embodiment of this invention is elucidated in the following paragraphs referring to the accompanied drawings.

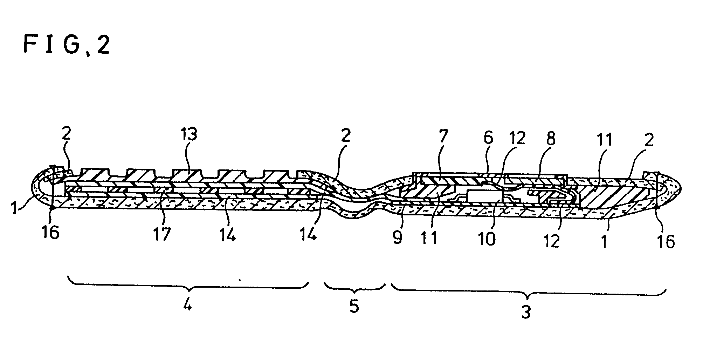

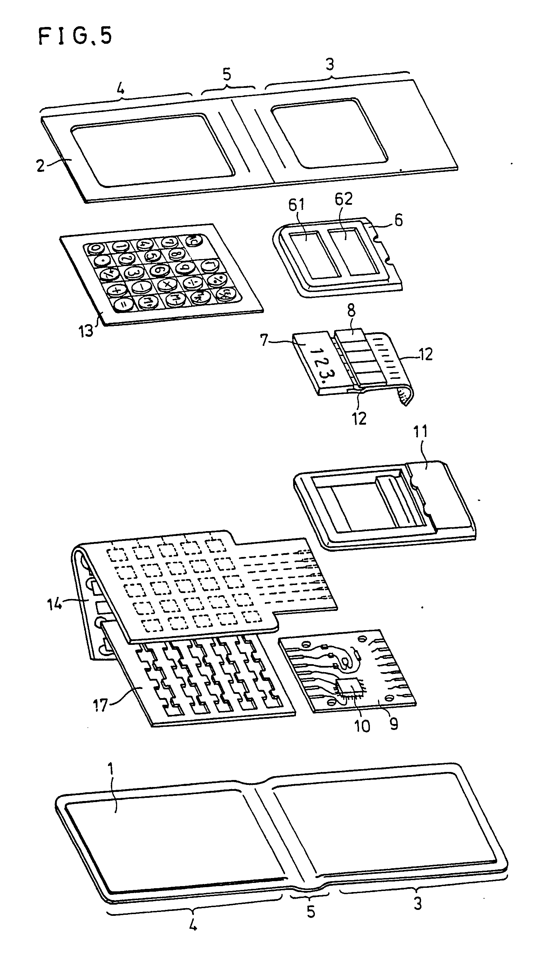

In FIG. 2, FIG. 3 and FIG. 5, an external member 1 is made of flexible material, such as flexible vinyl resin sheet or natural or artificial leather and is formed in rectangular-sheet. The periphery of the external member 1 is folded back for enforcement of the peripheral part or for connection to other members. An internal member 2 is made of substantially the same material as the external member 1 and the peripheral part of the internal member 2 and the peripheral part of the external member 1 are sewed with a thread 16. A panel part 6 is made of a thin sheet of aluminum, etc. The peripheral parts of the panel part 6 is slightly bent and the panel part 6 is fixed to by engaging with said internal member 2. A display means 7 is made of liquid crystal device whose peripheral part is held by the panel part 6 in a manner that the central part for displaying numerals, etc. is exposed through a window 61 formed on the panel part 6. A battern 8 is preferably a set of solar cells, etc. whose peripheral part is held by the panel part 6 and whose center part is disposed to be exposed through another window 62 formed on the panel part 6. The first film-type printed circuit substrate 9 is made of a flexible printed circuit substrate and is held to the external member, for example, by using adhesive material. A pattern of circuits is formed by using print circuit method art on the surface of the first film-type printed circuit substrate. An LSI chip 10 is fixed on the first film-type printed circuit substrate 9 and is provided with electric circuits such as an operation circuit for calculation or for playing a game and a driving circuit for said display means 7 and so on. A frame 11 is made of resilient plastics, etc. and fixes the LSI chip 10 of the first film-type printed circuit substrate 9, the liquid crystal display means 7 and the solar cell battery 8, etc. A second printed circuit substrate 12, which is a film-type connector, is formed in sheet-like and flexible configuration and connects the first film-type printed circuit substrate 9, the display means 7 and the solar cell battery 8. These connection parts between the first film-type printed circuit substrate 9, the display means 7 and the solar cell battery 8 are securely connected by using, for instance, heat-seal method. The push key cover sheet 13 is held at its peripheral part by the internal member 2 and a pattern of numerals and letters for the push key is printed on its surface and the printed parts of the surface are formed convex for maintaining the operation of push key and key stroking. The flexible third printed substrate 14 is arranged under the key cover sheet 13 and conductive layers, which are corresponding to said key pattern, are coated on the rear surface of the third printed substrate 14. The third printed circuit substrate 14 is folded in two with its rear surface inside so that the confronting conductive layers form key contacts. The film spacer 17 is made of insulating elastic material and inserted between the folded third printed circuit substrate 14 and has many holes corresponding to said key contacts. The terminals of the third printed circuit substrate 14 are electrically connected to the first film-type printed circuit substrate 9 by means of heat-seal method.

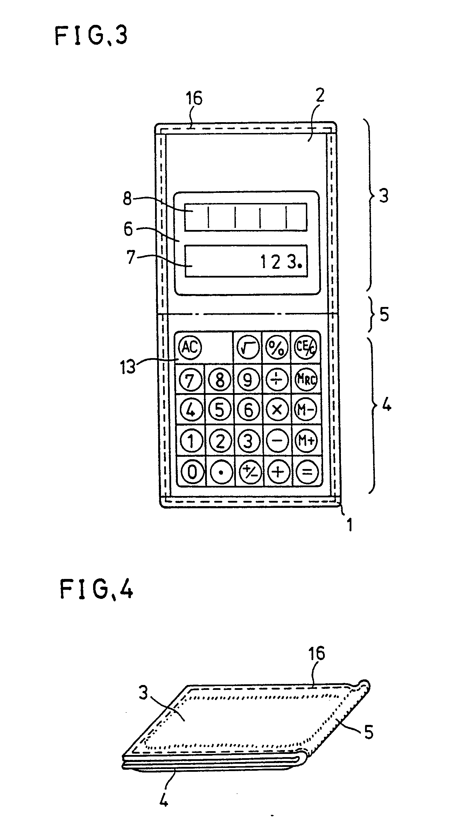

The pocket electronic calculator of this present invention is divided into an upper part 3, a lower part 4 and hinge part 5, as shown in FIG. 3.

According to above-mentioned embodiment, the third printed substrate 14 is inserted between the external member 1 and the internal member 2. The key cover sheet 13 which is disposed at said lower part 4 and the third printed circuit susbtrate 14 forms a switch matrix. The film spacer 17 serves to insulate the key contacts when the key cover sheet 13 is not pressed (i.e., the push key is not pushed). Numerals or function data which are input by pressing desired key part of the key cover sheet 13 are operated in the LSI chip 10 supplied with electric power from the battery 8, and the results of the operation are displayed on the display means 7 through the driving circuit for the display means 7. Thus the electronic calculator operates. The above-mentioned operation is performed when the electronic calculator is used for calculation. And when the electronic calculator is carried, the electronic calculator is folded in two at the hinge part 5, putting the key cover sheet 13 and display means 7 inside as shown in FIG. 4.

According to above-mentioned embodiment, all the lower part 4 and all the hinge part 5 are made of flexible or soft material concerning the upper part 3, the panel part 6 is half flexible and half rigid, and the display part 7 and the battery 8 which are held by the panel part 6 are rigid, but the display part 7 and the battery 8 are connected with the flexible film connector 12. Therefore the pocket electronic calculator of this invention is as a whole very flexible, and since it does not need further case for carrying, it can be carried as a very thin type calculator as a whole.

Furthermore, in the above-mentioned embodiment, it is also possible that the display means 7 and the battery 8 are made of flexible material and the panel part 6 is made of plastics or of leather, so that the whole upper part 3 has flexibility. In the above-mentioned embodiment, it is possible to make the frame 11 thin or to omit it.

Also, it is possible that the film connector 12, the first film-type printed circuit substrate 9 and the flexible third printed circuit substrate 14 are all made of one sheet. Also, when the display means 7 itself is flexible, it is easy to form the display means 7 and the film connector 12 in one body. Furthermore, it is possible to omit the key cover sheet 13 and to print directly the key letters on the surface of the flexible third printed circuit substrate 14. Alternatively, the key cover sheet 13 which is different from the internal member 2 can be omitted by directly printing the key letters on the surface of the internal member 2.

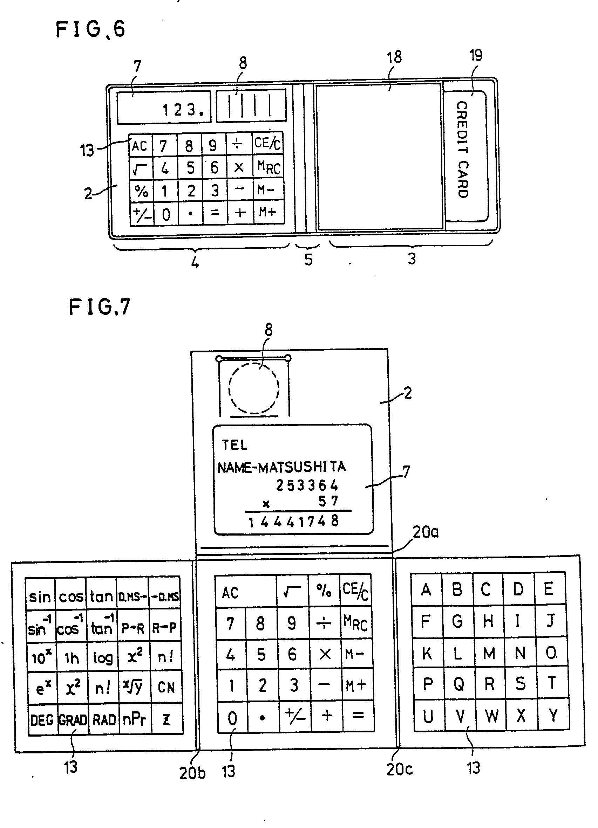

Furthermore, if the external member 1 and the internal member 2 are made of waterproof material and each connected part is made using water-resisting adhesive, the pocket electronic calculator can be made securely waterproof. The embodiment shown in FIG. 3 is an example in which the display means 7 and the battery 8 are disposed at the upper part 3, so that the area for the key operation is large and the key operation is superior. On the contrary, the embodiment in FIG. 6 is an example in which the pocket electronic calculator can be made small and useful. That is, in FIG. 6, the key cover sheet 13 which is arranged so as to be read when the pocket electronic calculator is open in lateral direction, the display means 7 and the battery 8 are disposed at the lower part 4, and at the upper part 3 there is a pocket part 18 in which thin small articles, for example, a credit card 19 can be put, and therefore the size of the pocket part 18 is preferably the size of a credit card 19. Alternatively, the size of the pocket part 18 can be made the size of a check book.

In FIG. 7 another embodiment of this invention is shown. As shown in FIG. 7 at both sides of the lower part 4 other push key members for key operation are provided, the members being made in the same way as the lower part 4. Therefore, this embodiment can have many key functions. The lower part 4 and said other members can be folded in three. Then it is possible that the display means 7 is made wide and when the switch of the battery 8 is not turn on, the display means 7 can be used as a mirror. As a result the embodiment can be used as a compact for lady. By using an exchangeable primary battery as the battery 8 other than the solar battery, it can have storage memory function, therefore the embodiment can be used as a small electronic note-book. Memorandums are written into this small electronic note-book pushing keys of the key cover sheet 13. When desired, it can be combined with a time-alarm function. Each key cover sheet 13a, 13b, 13c can be opened and closed at a hinge 20. This embodiment has an advantage of having many key switches.

As has been described above, according to the pocket electronic calculator of the present invention, since the pocket electronc calculator is very thin, by employing flexible external member, flexible internal member and flexible substrate, it is very compact when it is carried, and since it does not need a small note-book type case as belongings, it is advantageous in point of cost and it does not need a useless thick note-book type casing part, and furthermore when we carry it, it is warm and gentle to carrier, since it is generally made with soft materials. And it has the advantage that, since the majority parts of the calculator as such is made flexible, it is more durable than a conventional calculator against bendings, twistings and shocks, etc. Moreover, by using good quality leather, etc. as the material of the external member 1 or in other parts, it can have high-grade feeling.

By making it waterproof, we can use it outdoors without damage.

By making the display means 7 and the battery 8 of flexible material, it can increase its flexibility as a whole.

By forming the key cover sheet 13 and the third printed circuit substrate 14 in one body, the thickness of it can be reduced more.

By forming at least two of the first film-type printed circuit susbtrate 9, the second printed circuit substrate 12 and the third printed substrate 14 in one body, the number of parts of the pocket electronic calculator can be reduced.

By providing a card pocket on the lid part, it can hold a card other than the calculator.

By providing plural key cover sheets 13 and plural printed circuit substrates 14, etc. and connecting them using hinge structures and folding them when the pocket electronic calculator is carried, it can possess many functions.

By using the display means 7 as a mirror, it can have a function of a compact.

By making the display means 7 able to operate always by using a primary battery, it can be used as an electronic note-book.

### Claims

1. A pocket electronic calculator comprising: a keyboard (13, 14, 17) comprising numeral keys, four rules calculate keys and a function key, and covered with a flexible key cover sheet (13), a calculation circuit of an integrated circuit (10) executing a calculation based on a numeral signal, a four rules calculate signal and a function signal supplied from said keyboard, a battery (8) supplying a voltage to said calculation circuit, a liquid crystal panel (7) for displaying a signal of said calculation circuit, a flexible printed circuit substrate (9, 12, 14) for connecting electrically said keyboard, said calculation circuit, said battery and said liquid crystal panel, a cover (1) which is formed by folding a flexible sheet and connecting peripheral parts, in which said keyboard, said calculation circuit, said battery, said liquid crystal panel and said printed circuit substrate are enclosed, said cover having windows through which said keyboard is operated and said liquid crystal panel is exposed, characterized in that one end (14) of said flexible printed circuit substrate of small size is connected to said keyboard and the other end (12) of said flexible printed circuit substrate is connected to said liquid crystal panel (7) and said battery (8), both being of flexible material, that said flexible printed circuit substrate is capable of being folded, that a part (5) of said cover (1) which corresponds to a part of said flexible printed circuit substrate where said flexible printed circuit substrate is bendable, is bendable and that said bendable part (5) of said cover (1) is thinner than that of the other parts (3, 4) of said cover (1).

2. The calculator defined in claim 1, wherein the battery (8) and the liquid crystal display (7) face the keyboard when said calculator is folded.

3. The calculator defined in claim 1 or 2, wherein the keyboard comprises keys and key contacts, said contacts comprising a flexible printed circuit (14) substrate folded in two to provide confronting conductive layers, and an insulating film spacer (17) between said layers having holes therein corresponding to said contacts.

4. The calculator defined in claim 3, wherein the holes are arranged in rows with the holes in a row connected by slits in the spacer (17).

### Patentansprüche

1. Elektronischer Taschenrechner, umfassend: eine Tastatur (13, 14, 17), umfassend Zifferntasten, Tasten für die vier Rechenarten und eine Funktionstaste, wobei die Tastatur mit einem biegsamen Tastenabdeckblatt (13) abgedeckt ist, einen Berechnungsstromkreis einer integrierten Schaltung (10), der eine Berechnung ausführt auf der basis eines Ziffernsignals, eines Signals der vier Rechenarten und eines Funktionssignals, die von der Tastatur geliefert werden, eine Batterie (8), die eine Spannung an den Berechnungsstromkreis liefert, eine Flüssigkristalltafel (7) für das Anzeigen eines Signals des Berechnungsstromkreises, ein biegsames Substrat (9, 12, 14) der gedruckten Schaltung zum elektrischen Verbinden der Tastatur, des Berechnungsstromkreises, der Batterie und der Flüssigkristalltafel, eine Abdeckung (1), die gebildet ist durch das Falten eines biegsamen Blattes und durch Verbinden von Umfangsteilen, wobei die Tastatur, der Berechnungsstromkreis, die Batterie, die Flüssigkristalltafel und das Substrat der gedruckten Schaltung von der Abdeckung umschlossen sind, die Fenster aufweist, durch welche hindurch die Tastatur betätigt und die Flüssigkristalltafel freigelegt wird, dadurch gekennzeichnet, daß eine Ende (14) des Substrats der biegsamen gedruckten Schaltung kleiner Größe mit der Tastatur, und das andere Ende (12) des Substrats der biegsamen gedruckten Schaltung mit der Flüssigkristalltafel (7) und der Batterie verbunden ist, die beide aus biegsamem Material bestehen, daß das Substrat der biegsamen gedruckten Schaltung faltbar ist, daß ein Teil (5) der Abdeckung (1), der einem Teil des Substrats der biegsamen gedruckten Schaltung entspricht, wo das Substrat der biegsamen gedruckten Schaltung biegbar ist, biegbar ist, und daß der biegbare Teil (5) der Abdeckung (1) dünner als derjenige der anderen Teile (3, 4) der Abdeckung (1) ist.

2. Rechner nach Anspruch 1, wobei die Batterie (8) und die Flüssigkristallanzeige (7) der Tastatur zugewandt sind, wenn der Rechner gefaltet ist.

3. Rechner nach Anspruch 1 oder 2, wobei die Tastatur Tasten und Tastenkontake, von denen die Kontakte ein Substrat einer beigsamen gedruckten Schaltung (14) umfassen, welches zu zwei Teilen gefaltet ist, um einander gegenüberliegende leitende Lagen zu schaffen, und einen Isolierfolienabstandsteil (17) zwischen den Lagen aufweist, der Löcher besitzt entsprechend den Kontakten.

4. Rechner nach Anspruch 3, wobei die Löcher in Reihen angeordnet sind und die Löcher in einer Reihe durch Schlitze in dem Abstandsteil (17) verbunden sind.

**Revendications**

1. Calculatrice électronique de poche comprenant: un clavier (13, 14, 17) comportant des touches de chiffres, des touches de calcul de quatre règles et une touche de fonction, et recouvert d'une feuille flexible (13) de couverture de touche, un circuit de calcul d'un circuit intégré (10) exécutant un calcul basé sur un signal numérique, un signal de calcul de quatre règles et un signal de fonction fournis à partir du clavier, une pile (8) fournissant une tension au circuit de calcul, un panneau à cristaux liquides (7) pour afficher un signal du circuit de calcul, un substrat flexible à circuits imprimés (9, 12, 14) pour connecter électriquement le clavier, le circuit de calcul, la pile et le panneau à cristaux liquides, un couvercle (1) qui est formé en pliant une feuille flexible et en connectant des parties périphériques, dans lequel le clavier, le circuit de calcul, la pile, le panneau à cristaux liquides et le substrat à circuits imprimés sont enfermés, le couvercle comportant des fenêtres par l'intermédiaire desquelles le clavier est actionné et le panneau à cristaux liquides est exposé, caractérisée en ce que: une extrémité (14) du substrat flexible à circuits imprimés de petites dimensions est reliée au clavier et l'autre extrémité (12) du substrat flexible à circuits imprimés est connectée au panneau à cristaux liquides (7) et à la pile (8), toutes deux étant en matériau flexible, le substrat flexible à circuits imprimés pouvant être plié, en ce qu'une partie (5) du couvercle (1) qui correspond à une partie du substrat flexible à circuits imprimés, où le substrat flexible à circuits imprimés peut être cambré, peut être pliée et en ce que la partie pouvant être cambrée (5) du couvercle (1) est plus fine que les autres parties (3, 4) du couvercle (1).

2. Calculatrice selon la revendication 1, dans laquelle la pile (8) et le dispositif de visualisation à cristaux liquides (7) sont en regard du clavier lorsque la calculatrice est repliée.

3. Calculatrice selon la revendication 1 ou la revendication 2, dans laquelle le clavier comporte des touches et des contacts de touche, les contacts comprenant un substrat flexible à circuits imprimés (14) plié en deux pour founir des couches conductrices en regard, et une entretoise à pellicule isolante (17) entre les couches ayant des trous qui correspondent aux contacts.

4. Calculatrice selon la revendication 3, dans laquelle les trous sont disposés en rangées avec les trous d'une rangée reliés par des fentes ménagées dans l'entretoise (17).

## FIG.1 (Prior Art)

F I G . 2

FIG.3

FIG.4

FIG.5

## FIG.6

## FIG.7